# EUROPÄISCHE PATENTSCHRIFT

(11) **EP 2 037 004 B1**
(45) Veröffentlichungstag und Bekanntmachung des Hinweises auf die Patenterteilung: **23.02.2022**
(21) Anmeldenummer: 08159157.0
(22) Anmeldetag: 27.06.2008
(51) Int. Cl.: C23C 28/00, C23C 28/04, C23C 30/00, C23C 14/02, C23C 14/06, C23C 14/32

(54) **Schneidwerkzeug, sowie Verfahren zur Herstellung eines Schneidwerkzeugs**
Cutting tool and method for manufacturing a cutting tool
Outil de coupe, ainsi que procédé de fabrication d'un outil de coupe

(30) Priorität: 14.09.2007 EP 07116446
(43) Veröffentlichungstag der Anmeldung: 18.03.2009
(73) Patentinhaber: Oerlikon Surface Solutions AG, Pfäffikon, 8808 Pfäffikon SZ (CH)
(72) Erfinder: Vetter, Jörg, Dr., 51469 Bergisch Gladbach (DE)
(74) Vertreter: IPS Irsch AG

(56) Entgegenhaltungen:
- EP-A- 1 764 174
- WO-A-2004/059030
- WO-A-2006/084404
- WO-A-2006/099754
- US-A1- 2003 124 391

## Beschreibung

Die Erfindung betrifft ein Schneidwerkzeug zum Bearbeiten von Holz oder einem auf Holz basierenden Werkstoff, insbesondere Holzverbundwerkstoff, oder einem Kunststoff, sowie ein Verfahren zur Herstellung eines Schneidwerkzeugs gemäss dem Oberbegriff des unabhängigen Anspruchs der jeweiligen Kategorie.

Die Herstellung leistungsfähiger Werkzeuge und Bauteile wird meistens durch eine Beschichtung von deren Oberflächen realisiert. Eine wichtige Klasse solcher beschichteten Substrate sind Werkzeuge, neben anderen insbesondere zerspanende Werkzeuge, und im Bereich der Holzbearbeitung oder Kunststoffbearbeitung vor allem Schneidwerkzeuge. Von besonderem Interesse sind dabei rotierende Schneidwerkzeuge bzw. Drehschneidwerkzeuge zum Bearbeiten von Holz oder auf Holz basierenden Verbundwerkstoffen, oder von Kunststoffen da diese im Betriebszustand häufig mit sehr hohen Umdrehungszahlen rotieren und daher insbesondere im Bereich der Schneiden sehr hohen mechanischen und thermischen Belastungen ausgesetzt sind. Typische Substratmaterialien von Werkzeugen, die beschichtet werden, sind unter anderem Werkzeugstähle und Hartmetalle, aber auch alle möglichen anderen Substratmaterialien.

Da die Nutzung von Holz und Kunststoffen als Werkstoff in den letzten Jahren immer mehr zugenommen hat und Holz bzw. auch auf Holz basierende Werkstoffe und Kunststoffe im Markt immer attraktiver werden, ist auch die Nachfrage nach Werkzeugen zur zuverlässigen Bearbeitung der Werkstoffe Holz und Kunststoff entsprechend gestiegen. Dabei sind im Rahmen dieser Anmeldung unter Kunststoffen alle üblichen, dem Fachmann bekannten Kunststoffe, wie Plastik, Kunststoffverbundwerkstoffe, Elastomere, Gummi, insbesondere Hartgummi Kombinationswerkstoffe aus Holz und Kunststoffen, usw. zu verstehen.

Das trifft in besonderem Masse, aber nicht nur, auf die Laminierungsindustrie zu, wo z.B. Materialien mit verhältnismässig kleinem Durchmesser und geringer Länge laminiert werden um grössere Bretter oder Platten herzustellen, bzw. zur Weiterverarbeitung bestimmte Materialien grösseren Querschnitts hergestellt werden. Aufgrund von immer höheren Qualitätsansprüchen, aber auch aus Gründen der Zuverlässigkeit und Wirtschaftlichkeit beim Einsatz der entsprechenden Werkzeuge, werden zunehmend Werkzeuge verlangt, deren hoch belastete Schneiden an den Oberflächen, die in unmittelbaren Kontakt mit dem zu bearbeitenden Werkstoff Holz oder Kunststoff kommen, entsprechend veredelt sind.

Solche Werkzeuge sind zum Beispiel Zinkenschneider, ein Werkzeug, das bei der Herstellung von Laminatbrettern dazu verwendet wird, um eine in Längsrichtung des Holzes einzubringende zinkenartige Fuge zu erzeugen, die selbstverständlich bei jedem Brett möglichst identisch eingearbeitet werden soll, was höchste Anforderungen an die Präzision des Werkzeuges stellt.

Vergleichbare Anforderungen werden z.B. an mit Spitzen versehene Sägen gestellt, mit welchen zum Beispiel massive Blöcke, Balken oder Bretter gesägt werden müssen, aber auch zum Beispiel Bohrer, Fräsen, Formschneider und zahlreiche andere Werkzeuge zur Kunststoff- und Holzbearbeitung sind weitere prominente Beispiele.

Auch die Standzeit der Werkzeuge spielt natürlich eine wichtige Rolle, das heisst die Zeit, die ein solches Werkzeug eingesetzt werden kann, bis entweder zum Beispiel eine Schneide des Werkzeugs nachgeschliffen werden muss bzw. die Schneide oder das Werkzeug insgesamt gegen ein nicht verbrauchtes Werkzeug ausgetauscht werden muss.

Auch die Dicke z.B. der Sägeblätter soll möglichst gering gehalten werden, so dass einerseits durch das Sägen, vor allem in der Massenproduktion, möglichst wenig Kunststoff oder Holz in Form von Sägemehl verbraucht wird und andererseits auch eine höhere Genauigkeit in der Bearbeitung erreichbar ist, z.B. um immer kleinere Strukturen herauszuarbeiten. Dabei muss gleichzeitig verhindert werden, dass das Werkzeug aufgrund zu geringer Dicke in unstabile Betriebszustände kommt, so dass beispielweise im Fall eines Sägewerkzeuges ein vorgegebener Bearbeitungsweg nicht mehr eingehalten werden kann, oder das Werkzeug aufgrund zu hoher Belastungen bricht oder reisst.

Ein weiterer wichtiger Punkt betrifft die Beschaffenheit der Oberfläche solcher Schneidwerkzeuge. Es ist bekannt, dass beim Bearbeiten von Kunststoffen, Holz oder Holz basierten Werkstoffen an den Oberflächen der Schneidwerkzeuge Ablagerungen aus Kunststoffpartikeln, harzhaltige oder harzartige Ablagerungen, oder Ablagerungen, die Kautschuk, Klebstoffe, Gummilösungen, Konservierungsmittel aller Art oder andere organische oder anorganische Bestandteile des zu bearbeitenden Kunststoffs oder Holzwerkstoffs oder Holzverbundwerkstoffes auftreten können. Wenn z.B. ein Kunststoff oder ein Holzwerkstoff oder ein Holzverbundwerkstoff geschnitten wird, können sich die vorgenannten Bestandteile des Werkstoffs, die beim Schneiden verstreut werden, am Schneidwerkzeug ablagern. Insbesondere im Bereich der Schneide können sich die abgelagerten Bestandteile verfestigen und zunehmend weiter ablagern. Diese Phänomen nennt man in der Fachsprache Ablagerung von "Gum", wobei mit "Gum" nicht nur gummiartige Ablagerungen gemeint sind, sondern alle Ablagerungen, wie sie teilweise zuvor exemplarisch zum Teil bereits genannt wurden, die beim Bearbeiten von Kunststoffen und Holzwerkstoffen mit Schneidwerkzeugen auftreten können.

In aller Regel sind diese Ablagerungen von Gum unabhängig von der Schärfe der Schneide und sie treten sogar auf, wenn die Schneide noch neu und ungebraucht ist. Dabei liegen die Ablagerungen nicht nur in abgelagertem und angesammelten Zustand vor, sondern auch in einem dicht verfestigten Zustand, der vermutlich durch Verhärtung auf Grund von Polymerisationsvorgängen oder anderen, auch thermisch bestimmten Vorgängen von bestimmten Komponenten des Kunststoffes bzw. des Holzwerkstoffs entsteht. Die Ablagerungen sind dabei häufig so hartnäckig, dass sie kaum mit mechanischen oder anderen Mitteln entfernt werden können, so dass das Schneidwerkzeug durch die Ablagerungen unbrauchbar wird und ausgetauscht werden muss, obwohl die Schneide an sich noch genügend scharf ist.

In bestimmtem Fällen ist es dabei möglich, die Ablagerungen zum Beispiel mittels verschiedener Lösungsmittel wieder abzulösen, was natürlich aufwendig und entsprechend teuer ist.

Diese und weitere Probleme, zum Beispiel in Bezug auf eine zu grosse Rauheit der Oberfläche, was einerseits die Ablagerungen weiter begünstigt und andererseits beim Schneidvorgang eine unerwünscht hohe Reibung zwischen Schneidwerkzeug und einem zu bearbeitendem Werkstoff hervorruft, sind seit längerem bekannt und wurden teilweise zum Beispiel in der DE 694 25 277 T3 für den Fall von Holzwerkstoffen bereits diskutiert, deren Inhalt hiermit in die vorliegende Anmeldung vollumfänglich inkorporiert ist. Andere Beispielen von Stand der Technik sind WO2004/059030, WO2006/084404, WO2006/099754, EP1764174, und US2003/124391.

In Bezug auf die Oberflächenbeschaffenheit der Schneidwerkzeuge schlägt die DE 694 25 277 T3 vor, eine äusserste Oberfläche der Flanke einer Seitenschneide mit einem Überzug zu versehen, der aus Chrom oder einer Chromverbindung mit einem Nitrid, einem Karbid, einem Kohlenstoffnitrid bzw. einem Karbonitrid gebildet wird.

Das heisst, die Autoren der DE 694 25 277 T3 schlagen vor, als äusserste Beschichtung auf einer Schneide eines Schneidwerkzeugs entweder eine reine Chrom-Beschichtung mittels Hartverchromung aufzubringen, oder mittels eines physikalischen Dampfabscheideverfahrens (PVD) CrN oder eine Verbindung enthaltend Chrom und Kohlenstoff oder eine Verbindung enthaltend Chrom, Kohlenstoff und Stickstoff abzuschneiden, wobei in Bezug auf Chromverbindungen konkret nur die Eigenschaften von Oberflächen diskutiert wurden, die entweder aus reinem Chrom oder aus CrN bestehen.

Diese in der DE 694 25 277 T3 diskutierten Schichten mögen gegenüber dem übrigen Stand der Technik möglicherweise eine gewisse Verbesserung bringen. Jedoch haben sich in der Praxis drei entscheidende Nachteile heraus kristallisiert.

Erstens können auch diese Schichten nicht in allen Fällen die Ablagerung des oben näher definierten Gum in genügendem Ausmass verhindern. Ein zweiter wesentlicher Nachteil ist, dass die in der DE 694 25 277 T3 vorgeschlagenen Verfahren zur Herstellung der Oberflächen auf den Werkzeugen aus Sicht der Umwelt teilweise problematisch sind. So ist das Hartverchromen bekanntermassen ein elektrochemischer Prozess mit bedenklichen Auswirkungen auf die Arbeitsumgebung und entsprechend problematischen Abfallprodukten. Und drittens sind diese Werkzeuge nur zur Bearbeitung von Holzwerkstoffen und nicht zur Bearbeitung von Kunststoffen geeignet.

Für die Herstellung der in der DE 694 25 277 T3 beschriebenen Kombinationsschichten müssen darüber hinaus zum Teil ganz verschiedene Verfahren, wie Hartverchromen und PVD kombiniert werden, was die Beschichtungsverfahren aufwendig und teuer macht.

Die Aufgabe der Erfindung ist es daher, ein verbessertes Schneidwerkzeug zum Bearbeiten von Holz oder einem auf Holz basierenden Werkstoff, sowie auch von Kunststoffen bereitzustellen, das besonders einfach und kostengünstig herzustellen ist und das zumindest im Bereich der Oberflächen der Schneiden derart geartet ist, dass im Betriebszustand des Schneidwerkzeugs die aus dem Stand der Technik bekannten Ablagerung weitgehend vermieden werden, wobei gleichzeitig eine genügende Härte, Abriebfestigkeit und Haftfestigkeit der Oberfläche garantiert ist und, wie erwähnt, neben der Bearbeitung von Holzwerkstoffen auch für die Bearbeitung von Kunststoffen geeignet ist.

Eine weitere Aufgabe der Erfindung ist es, ein Verfahren zur Herstellung eines entsprechenden Schneidwerkzeugs bereit zu stellen.

Die diese Aufgaben lösenden Gegenstände der Erfindung sind durch die Merkmale der unabhängigen Ansprüche gekennzeichnet.

Die jeweiligen abhängigen Ansprüche beziehen sich auf besonders vorteilhafte Ausführungsformen der Erfindung.

Die Erfindung betrifft somit ein Schneidwerkzeug zum Bearbeiten von Holz oder einem auf Holz basierenden Werkstoff, insbesondere Holzverbundwerkstoff, oder einem Kunststoff, wobei auf einer Oberfläche (2) einer Schneide (3) des Schneidwerkzeugs ein Schichtsystem (4) zur Bildung einer Oberflächenbeschichtung vorgesehen ist, dadurch gekennzeichnet, dass eine äusserste Oberflächenschicht (41, 4100, 4101) des Schichtsystems (4) aus einer Zusammensetzung der Form [Cr₁₋ₓOₓ]_{z}XₐC_{b}N_{c} mit 0.05 < x <0.75 und 0 < z ≤ 1, 0 ≤ a <1, 0 ≤ b<1, 0 ≤ c<1 und z+a+b+c = 1 gebildet ist, und X ein Element aus der Gruppe der chemischen Elemente bestehend aus Si, B, Al, Mn, Fe, Co, Ni, Cu, Sc, Y, La, Th, den Elementen der Gruppe der Lanthanoide, und den Elementen der Gruppe IIa des Periodensystems der Elemente ist.

Nur zur Klarstellung sei hier nochmals kurz erwähnt, dass die Gruppe der Lanthanoide die chemischen Elemente Ce, Pr, Nd, Pm, Sm, Eu, Gd, Tb, Dy, Ho, Er, Tm, Yb und Lu enthält, und die Gruppe IIa des Periodensystems der Elemente aus den chemischen Elementen Be, Mg, Ca, Sr, Ba und Ra besteht.

Wesentlich für die Erfindung ist es somit, dass eine äusserste Oberflächenschicht, die erfindungsgemäss auf eine Schneide des Schneidwerkzeugs aufgebracht wird, mindestens die Elemente Chrom und Sauerstoff enthält. Es hat sich nämlich überraschend gezeigt, dass derartige Oberflächenschichten schädliche Ablagerungen von Gum viel besser verhindern, als reine Chromschichten oder Chromnitrid Schichten, die jeweils keinen Sauerstoff enthalten. Es ist somit eine wesentliche Erkenntnis der Erfindung, dass der zusätzliche Sauerstoff in Kombination mit Chrom in den Schichten dafür verantwortlich ist, dass die Ablagerung von Gum auf der Oberfläche der Schneidwerkzeuge im Wesentlichen verhindert wird.

Darüber hinaus können die Oberflächenschichten der vorliegenden Erfindung, selbst komplizierte Schichtsysteme aus verschiedenen Teilschichten, in einem besonders einfachen Verfahren, nämlich mittels PVD, besonders bevorzugt aber durch Lichtbogenverdampfung auf die Schneidwerkzeuge aufgebracht werden. Es ist dabei lediglich eine Verdampferkathode notwendig, die Cr oder eventuell noch eine andere Komponenten X, also ein Element oder mehrere Elemente aus der Gruppe der chemischen Elemente bestehend aus Si, B, Al, Mn, Fe, Co, Ni, Cu, Sc, Y, La, Th, den Elementen der Gruppe der Lanthanoide, und den Elementen der Gruppe IIa des Periodensystems der Elemente, in einer entsprechenden Legierung, Mischung oder chemischen Verbindung enthält, während das neben Chrom wesentliche Element Sauerstoff, aber z.B. in speziellen Fällen auch Stickstoff und Kohlenstoff, z.B. einfach über entsprechende Prozessgase in an sich bekannter Weise dem Beschichtungsvorgang in einer Beschichtungskammer zugeführt werden können, wobei C, O und N in speziellen Fällen natürlich auch Teil des Verdampfermaterials der Verdampferkathode sein können.

Bevorzugt ist dabei die Chromoxidgruppe [Cr₁₋ₓOₓ]_{z} CrO₂, oder CrO₃, oder Cr₂O₃. Alternativ kann die Chromoxidgruppe [Cr₁₋ₓOₓ]_{z} auch ein unterstöchiometrisches Chromoxid oder ein nicht-stöchiometrisches Chromoxid mit hohem oder niedrigem Sauerstoffgehalt sein.

In einem für die Praxis besonders wichtigen Ausführungsbeispiel enthält die äusserste Oberflächenbeschichtung der Schneide des Schneidwerkzeug nur die Elemente Chrom und Sauerstoff, das heisst die äusserste Oberflächenbeschichtung ist eine [Cr₁₋ₓOₓ]_{z} -Schicht. Es gilt also a = 0, b = 0 und C = 0 in der allgemeinsten chemischen Charakterisierung einer erfindungsgemässen Schicht.

Es versteht sich, dass in bestimmten Fällen eine erfindungsgemässe Oberflächenbeschichtung neben Cr und O auch zusätzlich Stickstoff, also N, Kohlenstoff, also C und / oder X, d.h. eines oder mehrere der Elemente aus der Gruppe der chemischen Elemente bestehend aus Si, B, Al, Mn, Fe, Co, Ni, Cu, Sc, Y, La, Th, den Elementen der Gruppe der Lanthanoide, und den Elementen der Gruppe IIa des Periodensystems der Elemente enthalten kann. Es kann also auch nur a = 0, oder nur b = 0 oder nur c =0 gelten oder es kann sowohl a, als auch b, als auch c verschieden von Null sein, das heisst es können zusätzlich zu Cr und O auch noch gleichzeitig die Elemente aus der Gruppe X sowie N und C enthalten sein.

Die Wahl der zusätzlichen Komponenten kann dabei unter anderem davon abhängen, welche Härte bzw. Haftfestigkeit der Oberflächenschicht eingestellt werden soll, bzw. welche Art von Kunststoff- oder Holzmaterialien im Speziellen bearbeitet werden sollen. Je nachdem welche Zusammensetzung die zu verhindernden Ablagerungen haben, kann durch geeignete Wahl der zusätzlichen chemischen Elemente im Schichtsystem die abweisende Wirkung gegenüber Ablagerungen noch weiter optimiert werden bzw. die Härte und / oder Abriebfestigkeit und / oder Haftfestigkeit und / oder der Reibungskoeffizient der Schichten eingestellt werden.

In einem anderen Ausführungsbeispiel umfasst das Schichtsystem zusätzlich eine CrN-Teilschicht und / oder eine CrN-Gradienten-Teilschicht und / oder eine Cr-Teilschicht und / oder eine CrO-Teilschicht und / oder eine CrCO-Teilschicht und / oder eine [Cr₁₋ₓOₓ]_{z}XₐC_{b}N_{c}-Teilschicht.

Dabei kann die Cr-Teilschicht zum Beispiel als Haftschicht direkt auf der Oberfläche der Schneide vorgesehen sein.

In ganz speziellen Fällen kann das Schichtsystem mindestens zwei auf der Oberfläche der Schneide übereinander angeordnete Teilschichtsysteme umfassen, insbesondere zwei identische Teilschichtsysteme.

Insbesondere umfasst das Teilschichtsystem in einem speziellen Ausführungsbeispiel der vorliegenden Erfindung eine Schichtabfolge von drei aufeinander folgenden Teilschichten, nämlich einer Cr-Teilschicht, einer CrXNC-Teilschicht und einer [Cr₁₋ₓOₓ]_{z}XₐC_{b}N_{c}-Teilschicht derart, dass die Cr-Teilschicht jeweils der Oberfläche der Schneide am nächsten zugewandt ist und die [Cr₁₋ₓOₓ]_{z}XₐC_{b}N_{c}-Teilschicht jeweils der äussersten Oberflächenschicht am nächsten zugewandt ist.

Das heisst, die verschiedenen erwähnten Teilschichten können ganz bestimmte Funktionen erfüllen. So fungiert die Cr-Teilschicht bevorzugt als Haftschicht zur Haftung auf dem metallischen Körper des Schneidwerkzeugs oder zur Haftung auf einer darunter liegenden Teilschicht. Auch kann die Cr-Schicht als Zwischenschicht zwischen anderen Teilschichten dazu beitragen, mechanische Verspannungen in einem erfindungsgemässen Schichtsystem zu reduzieren.

Auch können z.B. die [Cr₁₋ₓOₓ]_{z}XₐC_{b}N_{c}-Schichten oder auch die anderen hier erwähnten Teilschichten in verschiedenen Zusammensetzungen als Gradientenschichten ausgestaltet sein, so dass eine solche Gradientenschicht zwischen zwei Schichten eine Anpassung von zwei verschiedenen Schichten bewirkt, in dem die Gradientenschicht in der Nähe der ersten Schicht ungefähr die chemische Zusammensetzung der ersten Schicht hat und in der Nähe der zweiten Schicht ungefähr die chemische Zusammensetzung der zweiten Schicht hat. So können besonders gut Spannungen in einem Mehrschichtsystem reduziert werden und die Haftfestigkeit zwischen zwei unterschiedlichen Teilschichten durch Anpassung der verschiedenen chemischen Zusammensetzung bzw. durch Anpassung der verschiedenen Gittergeometrien drastisch verbessert werden.

Eine Schichtdicke der Teilschicht eines erfindungsgemässen Schichtsystems kann zwischen 0.05µm und 5µm liegen, wobei eine Gesamtdicke des Schichtsystems zwischen 0.01 µm und 50µm liegen kann. Es ist dabei möglich, dass in bestimmten Fällen eine sehr grosse Anzahl von Teilschichten, bis zu 1000 Teilschichten und mehr vorgesehen werden, was z.B. die Standzeiten des Werkzeugs massiv erhöhen kann, aber auch, z.B. bei sehr dünnen Schneiden die mechanische Stabilität verbessern kann.

Bevorzugt liegt eine Härte HV0.1 der Teilschicht zwischen 1000HV.01 und 3000HV.01 und eine Eigenspannung der Teilschicht liegt zwischen 0.1GPa und 5GPa.

Im Speziellen ist ein erfindungsgemässes Schneidwerkzeug eine Säge, ein Messer, ein Hobel, ein Stecheisen, ein Zinkenschneider, ein Dielenschneider, ein Fussbodenschneider, ein Formteilschneider, ein Leistenschneider oder ein rotierbares Schneidwerkzeug, oder ein anderes rotierbares oder nicht rotierbares Schneidwerkzeug zur Bearbeitung von Kunststoff oder Holz.

Die Erfindung betrifft weiterhin ein Verfahren zum Herstellen eines erfindungsgemässen Schneidwerkzeugs, wobei das Schneidwerkzeug unter Verwendung eines PVD-Verfahrens beschichtet wird, umfassend die folgende Schritte:
Bereitstellen einer Vakuum-Beschichtungskammer mit einer Lichtbogen-Verdampfungsquelle und Platzieren eines Schneidwerkzeug an einem rotierbaren Substrathalter der Beschichtungskammer. Sodann Erzeugung eines Hochvakuums in der Beschichtungskammer. Es erfolgt die Bildung einer Oberflächenbeschichtung umfassend ein Schichtsystem auf dem Schneidwerkzeug. Anschliessend erfolgt die Abscheidung einer äussersten CrNO-Oberflächenschicht des Schichtsystems mittels Lichtbogenverdampfung, wobei der äussersten Oberflächenschicht aus einer Zusammensetzung der Form [Cr₁₋ₓOₓ]_{z}XₐC_{b}N_{c} mit 0.05 < x < 0.75 und 0 < z ≤ 1, 0 ≤ a <1, 0 ≤ b < 1, 0 ≤ c < 1 und z+a+b+c = 1 gebildet ist, und X ein Element aus der Gruppe der chemischen Elemente bestehend aus Si, B, Al, Mn, Fe, Co, Ni, Cu, Sc, Y, La, Th, den Elementen der Gruppe der Lanthanoide, und den Elementen der Gruppe IIa des Periodensystems der Elemente ist.

In einer bevorzugte ausführungsform des Verfahrens umfasst das Bilden der Oberflächenbeschichtung die folgende schritten:
- Erhöhung der Temperatur auf 400°C für eine Stunde mittels eines Strahlungsheizers;
- Ionenreinigung einer Oberfläche des Schneidwerkzeugs für 30min mittels Ar-Ionen;
- Beschuss der Oberfläche des Schneidwerkzeugs für 2min mittels Cr-Ionen unter einer Vorspannung von 800V;
- Abscheidung einer 100nm dicken Cr-Teilschicht als Haftschicht auf der Oberfläche des Schneidwerkzeugs mittels Lichtbogen-Verdampfung unter Verwendung einer Bias-Vorspannung von 100V;
- Einlass eines Stickstoffgases und Einstellung einer Bias-Spannung von 60V;
- Abscheidung einer CrN-Gradienten-Teilschicht auf der Cr-Haftschicht mittels Lichtbogen-Verdampfung, wobei während der Abscheidung der CrN-Gradienten-Teilschicht ein Stickstoff Partialdruck linear von 0.1Pa auf 2Pa erhöht wird, bis eine Schichtdicke (d) der CrN-Gradienten-Teilschicht von 2mm erreicht wird;
- Einlass von Sauerstoff im Mischungsverhältnis Stickstoff zu Sauerstoff wie 1 zu 4.

Im Folgenden Wird die Erfindung an Hand der Zeichnung näher erläutert. Es zeigen in schematischer Darstellung:
- Fig. 1: ein erstes einfaches Ausführungsbeispiel eines erfindungsgemässen Schneidwerkzeugs;
- Fig. 2: ein zweites Ausführungsbeispiel mit einer CrN-Teilschicht;
- Fig. 3: ein drittes Ausführungsbeispiel mit einer Cr-Haftschicht;
- Fig. 4: ein Ausführungsbeispiel mit Teilschichtsystemen.

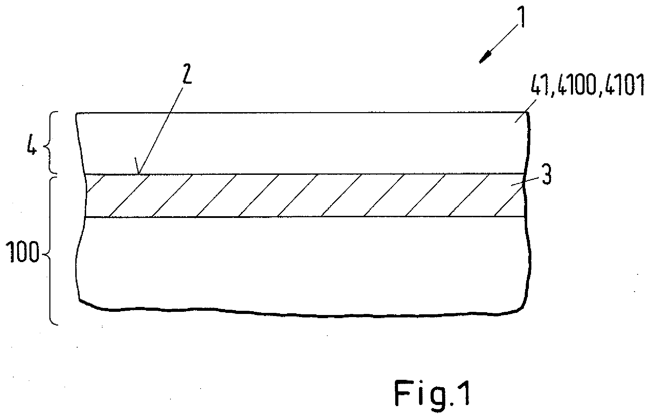

In Fig. 1 ist in einem ersten sehr einfachen Ausführungsbeispiel ein erfindungsgemässes Schneidwerkzeug schematisch dargestellt, das im Folgenden gesamthaft mit dem Bezugszeichen 1 bezeichnet wird. Das Schneidwerkzeug 1 wird dabei durch Beschichtung einer Schneide 3 eines Schneidwerkzeug-Rohlings 100 gebildet.

Auf der nur ausschnittsweise dargestellten Schneide 3 des Schneidwerkzeugs 1 ist in dem ganz einfachen Beispiel der Fig. 1 ein Schichtsystem 4 durch Lichtbogenverdampfung aufgebracht worden, das lediglich die äusserste Oberflächenschicht 41, 4100, 4101 aufweist, die neben Chrom und Sauerstoff in einem Fall zusätzlich noch ein oder mehrere Elemente der Gruppe X umfassen kann und / oder zusätzlich noch Stickstoff und / oder Kohlenstoff umfassen kann. Dabei kann in der äussersten Oberflächenschicht 41, 4100, 4101 auch noch eine Färbung eingebracht werden, z.B. indem in an sich bekannter Weise ein erhöhter Sauerstoffanteil vorgesehen wird, oder eine andere an sich bekannte Massnahme zur Farbgebung ergriffen wird.

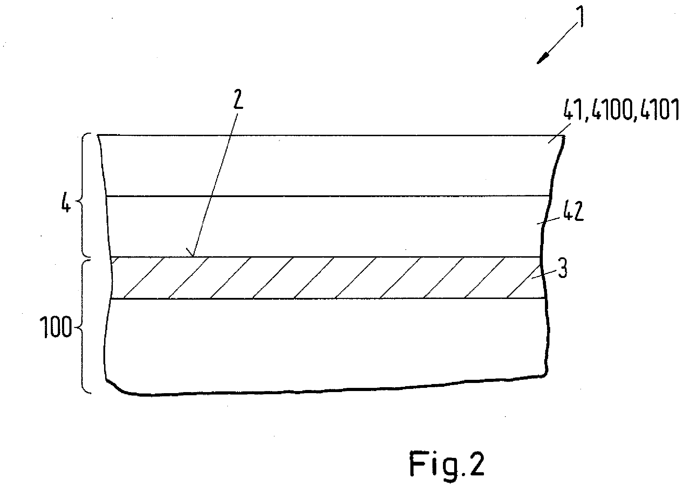

In den Fig. 2 bis 4 sind exemplarisch weitere, für die Praxis besonders wichtige Ausführungsbeispiele eines erfindungsgemässen Schneidwerkzeugs 1 schematisch dargestellt.

Das Ausführungsbeispiel der Fig. 2 unterscheidet sich von demjenigen der Fig. 1 dadurch, dass zwischen der Schneide 3 und der äussersten Oberflächenschicht 41, 4100, 4101 zusätzlich noch eine CrN-Teilschicht 42 auf der Oberfläche 2 der Schneide 3 des Schneidwerkzeug-Rohlings 100 vorgesehen ist. Diese zusätzliche CrN-Schicht 42 erhöht zum Beispiel die Haftfestigkeit der äussersten Oberflächenschicht 41.

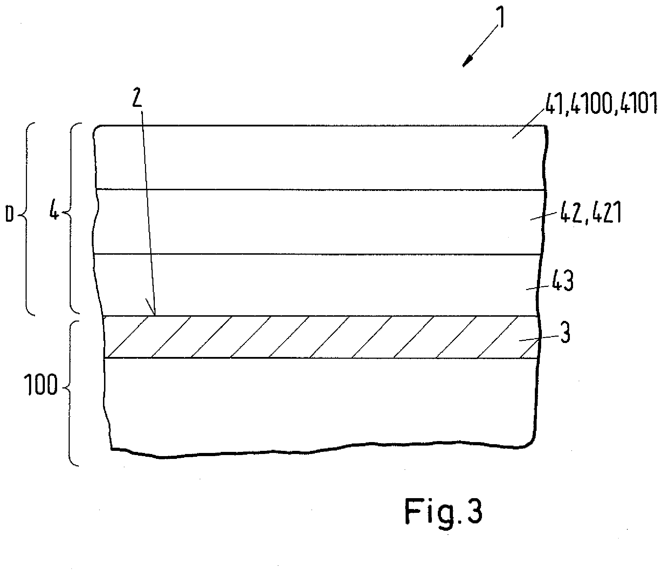

In Fig. 3 ist eine Fortentwicklung des Ausführungsbeispiels gemäss Fig. 2 dargestellt. Im Beispiel der Fig. 3, das sehr wichtig für die Praxis ist, ist auf der Oberfläche 2, d.h. zwischen der Oberfläche 2 des Schneidwerkzeug-Rohlings 100 und der CrN-Teilschicht 42, 421 noch eine reine Cr-Teilschicht 43 vorgesehen.

Die Cr-Teilschicht 43 verbessert insbesondere die Haftung des Schichtsystems 4 mit Gesamtdicke D auf der Oberfläche 2 der Schneide 3. Die CrN-Teilschicht 42 ist bevorzugt als CrN-Gradiententeilschicht 421 ausgebildet, deren chemische Zusammensetzung in der Nähe der Cr-Teilschicht 43 fast reines Chrom ist und in der Nähe der äussersten Oberflächenschicht 41, 4100, 4101 eine CrN Zusammensetzung hat. Durch eine solche Schichtfolge erhält man ein Schichtsystem 4, das besonders wenig innere Verspannungen aufweist und sehr gut auf der Oberfläche 2 der Schneide 3 haftet.

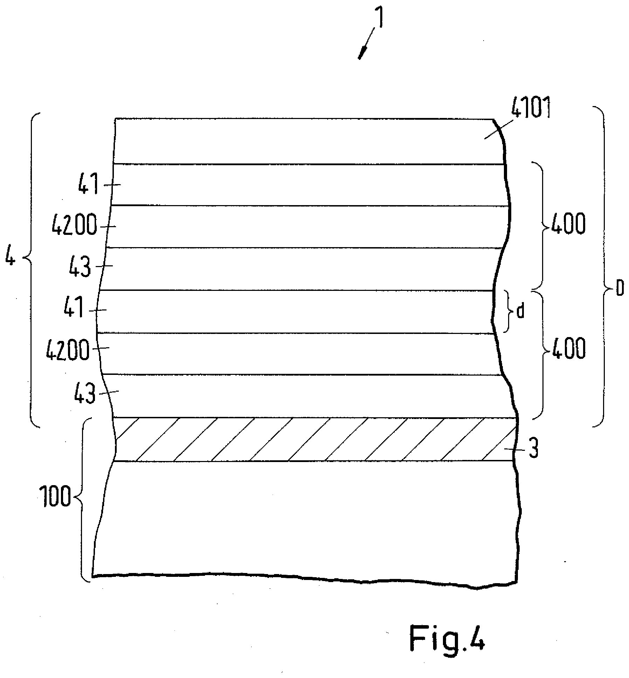

In Fig. 4 ist schliesslich ein sehr differenzierter Schichtaufbau als spezielles Ausführungsbeispiel der vorliegenden Erfindung schematisch dargestellt.

Es handelt sich dabei um ein Schneidwerkzeug 1 mit einem Schichtsystem 4, wobei auf der Oberfläche 2 der Schneide 3 zwei identische Teilschichtsysteme 400, sowie als äusserste Oberflächenschicht 41 eine Oberflächenschicht 4101 vorgesehen ist, die einen besonders hohen Sauerstoffgehalt hat, so dass eine Färbung der Oberflächenschicht 4101 erreicht wird.

Die beiden Teilschichtsysteme 400 bestehen jeweils aus drei einzelnen Teilschichten 43, 4200, 41 der jeweiligen, eventuell verschiedenen Dicke d, wobei die Teilschicht 43 zur Verbesserung der Haftung eine reine Cr-Teilschicht 43 ist, die Teilschicht 4200 zur Stressminderung als CrXNC-Teilschicht 4200 ausgebildet ist und die Teilschicht 41 eine [Cr₁₋ₓOₓ]_{z}XₐC_{b}N_{c}-Teilschicht 41 ist, die insbesondere eine gute Anpassung der farbigen, zum Beispiel leicht bläulichen Oberflächenschicht 4101 an die darunter liegenden Teilschichten garantiert.

Es versteht sich, dass die zuvor beschriebenen Ausführungsbeispiele der Erfindung, je nach Anwendung auch in jeder geeigneten Weise kombinierbar sind und insbesondere die exemplarisch dargestellten Schichtabfolgen auch in anderer Weise realisiert sein können und eine oder mehrere der Schichten in einem speziellen Ausführungsbeispiel eines erfindungsgemässen Schichtsystems ganz fehlen können oder in einem anderen Ausführungsbeispiel in ein und demselben Schichtsystem auch mehrfach vorkommen können.

## Patentansprüche

1. Schneidwerkzeug zum Bearbeiten von Holz oder einem auf Holz basierenden Werkstoff, insbesondere Holzverbundwerkstoff, oder einem Kunststoff, wobei auf einer Oberfläche (2) einer Schneide (3) des Schneidwerkzeugs ein Schichtsystem (4) zur Bildung einer Oberflächenbeschichtung vorgesehen ist, **dadurch gekennzeichnet, dass** eine äusserste Oberflächenschicht (41, 4100, 4101) des Schichtsystems (4) aus einer Zusammensetzung der Form [Cr₁₋ₓOₓ]_{z}XₐC_{b}N_{c} mit 0.05 < x < 0.75 und 0 < z ≤ 1, 0 ≤ a < 1, 0 ≤ b < 1, 0 ≤ c < 1, und z+a+b+c = 1 gebildet ist, und X ein Element aus der Gruppe der chemischen Elemente bestehend aus Si, B, AI, Mn, Fe, Co, Ni, Cu, Sc, Y, La, Th, den Elementen der Gruppe der Lanthanoide, und den Elementen der Gruppe Ila des Periodensystems der Elemente ist.

2. Schneidwerkzeug nach Anspruch 1, wobei die Chromoxidgruppe [Cr₁₋ₓOₓ]_{z} CrO₂, CrO₃ oder Cr₂O₃ ist.

3. Schneidwerkzeug nach Anspruch 1, wobei die Chromoxidgruppe [Cr₁₋ₓOₓ]_{z} ein unterstöchiometrisches Chromoxid oder nicht-stöchiometrisches Chromoxid mit hohem oder niedrigem Sauerstoffgehalt ist.

4. Schneidwerkzeug nach einem der vorhergehenden Ansprüche, wobei a = 0 ist und / oder b = 0 und / oder c = 0 ist.

5. Schneidwerkzeug nach einem der vorangehenden Ansprüche, wobei das Schichtsystem (4) zusätzlich eine CrN-Teilschicht (42) und / oder eine CrN-Gradienten-Teilschicht (421) und / oder eine Cr-Teilschicht (43) und / oder eine CrO-Teilschicht und / oder eine CrCO-Teilschicht und / oder eine [Cr₁₋ₓOₓ]_{z}XₐC_{b}N_{c}-Teilschicht umfasst.

6. Schneidwerkzeug nach Anspruch 5, wobei die Cr-Teilschicht (43) als Haftschicht direkt auf der Oberfläche (2) der Schneide (3) vorgesehen ist.

7. Schneidwerkzeug nach einem der Ansprüche 5 oder 6, wobei das Schichtsystem (4) mindestens zwei auf der Oberfläche (2) der Schneide (3) übereinander angeordnete Teilschichtsysteme (400) umfasst.

8. Schneidwerkzeug nach Anspruch 7, wobei die übereinander angeordneten Teilschichtsysteme (400) zwei identische Teilschichtsysteme (400) umfassen.

9. Schneidwerkzeug nach einem der Ansprüche 5 bis 8, wobei das Teilschichtsystem (400) eine Schichtabfolge von drei aufeinander folgenden Teilschichten, einer Cr-Teilschicht (43), einer CrXNC-Teilschicht (4200) und einer [Cr₁-ₓOₓ]_{z}XₐC_{b}N_{c} Teilschicht (41, 4100, 4101) derart umfasst, dass die Cr-Teilschicht (43) jeweils der Oberfläche (2) der Schneide (3) am nächsten zugewandt ist und die [Cr₁-ₓOₓ]_{z}XₐC_{b}N_{c} -Teilschicht (41, 4100, 4101) jeweils der äussersten Oberflächenschicht (41, 4100, 4101) am nächsten zugewandt ist.

10. Schneidwerkzeug nach einem der Ansprüche 5 bis 9, wobei eine Schichtdicke (d) der Teilschicht (41, 42, 43, 421, 4100, 4200) zwischen 0.05mm und 5mm liegt.

11. Schneidwerkzeug nach einem der vorangehenden Ansprüche, wobei eine Gesamtdicke (D) des Schichtsystems (4) zwischen 0.01mm und 50mm liegt.

12. Schneidwerkzeug nach einem der Ansprüche 5 bis 11, wobei eine Härte der Teilschicht (41, 42, 43, 421, 4100, 4200) zwischen 1000HV.01 und 3000HV.01 liegt.

13. Schneidwerkzeug nach einem der Ansprüche 5 bis 12, wobei eine Eigenspannung der Teilschicht (41, 42, 43, 421, 4100, 4200) zwischen 0.1GPa und 5GPa liegt.

14. Schneidwerkzeug nach einem der vorangehenden Ansprüche, wobei das Schneidwerkzeug eine Säge, ein Messer, ein Hobel, ein Stecheisen, ein Zinkenschneider, ein Dielenschneider, ein Fussbodenschneider, ein Formteilschneider, ein Leistenschneider oder ein rotierendes Schneidwerkzeug ist.

15. Verfahren zum Herstellen eines Schneidwerkzeugs (1) nach einem der vorangehenden Ansprüche, wobei das Schneidwerkzeug (1) unter Verwendung eines PVD-Verfahrens beschichtet wird, umfassen die folgenden Schritte:
- Bereitstellen einer Vakuum-Beschichtungskammer mit einer Lichtbogen-Verdampfungsquelle;
- Platzieren eines Schneidwerkzeugs (1) an einem rotierbaren Substrathalter der Beschichtungskammer;
- Erzeugung eines Hochvakuums in der Beschichtungskammer;
- Bildung einer Oberflächenbeschichtung umfassend ein Schichtsystem (4) auf dem Schneidwerkzeug (1);
- Abscheidung einer äussersten Oberflächenschicht (41) des Schichtsystems (4) mittels Lichtbogenverdampfung, wobei der äussersten Oberflächenschicht aus einer Zusammensetzung der Form [Cr₁-ₓOₓ]_{z}XₐC_{b}N_{c} mit 0.05 < x < 0.75 und 0 < z ≤ 1, 0 ≤ a < 1, 0 ≤ b < 1, 0 ≤ c < 1 und z+a+b+c = 1 gebildet ist, und X ein Element aus der Gruppe der chemischen Elemente bestehend aus Si, B, AI, Mn, Fe, Co, Ni, Cu, Sc, Y, La, Th, den Elementen der Gruppe der Lanthanoide, und den Elementen der Gruppe Ila des Periodensystems der Elemente ist.

16. Verfahren zum Herstellen eines Schneidwerkzeugs (1) nach Anspruch 15, wobei das Bilden der Oberflächenbeschichtung die folgenden Schritte umfasst:
- Erhöhung der Temperatur auf 400°C für eine Stunde mittels eines Strahlungsheizers;
- lonenreinigung einer Oberfläche (2) des Schneidwerkzeugs (1) für 30min mittels Ar-Ionen;
- Beschuss der Oberfläche (2) des Schneidwerkzeugs (1) für 2min mittels Cr-Ionen unter einer Vorspannung von 800V;
- Abscheidung einer 100nm dicken Cr-Teilschicht (43) als Haftschicht auf der Oberfläche (2) des Schneidwerkzeugs (1) mittels Lichtbogen-Verdampfung unter Verwendung einer Bias-Vorspannung von 100V;
- Einlass eines Stickstoffgases und Einstellung einer Bias-Spannung von 60V;
- Abscheidung einer CrN-Gradienten-Teilschicht (421) auf der Cr-Haftschicht (43) mittels Lichtbogen-Verdampfung, wobei während der Abscheidung der CrN-Gradienten-Teilschicht (421) ein Stickstoff Partialdruck linear von 0.1Pa auf 2Pa erhöht wird, bis eine Schichtdicke (d) der CrN-Gradienten-Teilschicht (421) von 2mm erreicht wird;
- Einlass von Sauerstoff im Mischungsverhältnis Stickstoff zu Sauerstoff wie 1 zu 4.

## Claims

1. A cutting tool for the machining of wood or a wood-based material, in particular a wood composite material, or a plastic, wherein a layer system (4) for the formation of a surface coating is present on a surface (2) of a cutting edge (3) of the cutting tool, **characterised in that** an outermost surface layer (41, 4100, 4101) of the layer system (4) is formed from a composition of the form [Cr₁₋ₓOₓ]_{z}XₐC_{b}N_{c} with 0.05 < x < 0.75 and 0 < z ≤ 1, 0 ≤ a <1, 0 ≤ b <1, 0 ≤ c < 1 and z+a+b+c = 1 and X being an element from the group of the chemical elements consisting of Si, B, Al, Mn, Fe, Co, Ni, Cu, Sc, Y, La, Th, the elements of the group of the lanthanides and the elements of the group 11a of the periodic system of the elements.

2. A cutting tool in accordance with claim 1, wherein the chromium oxide group [Cr₁₋ₓOₓ]_{z} is CrO₂, CrO₃ or Cr₂O₃,

3. A cutting tool in accordance with claim 1, wherein the chromium oxide group [Cr₁₋ₓOₓ]_{z} is an under-stoichiometric chromium oxide or a non-stoichiometric chromium oxide with a high or low oxygen content.

4. A cutting tool in accordance with any one of the previous claims, wherein a = 0 and/or b = 0 and/or c = 0.

5. A cutting tool in accordance with any one of the previous claims, wherein the layer system (4) additionally includes a CrN part layer (42) and/or a CrN gradient part layer (421) and/or a Cr part layer (43) and/or a CrO part layer and/or a CrCO part layer and/or a [Cr₁-ₓOₓ]_{z}XₐC_{b}N_{c} part layer.

6. A cutting tool in accordance with claim 5, wherein the Cr part layer (43) is provided as a bond layer directly on the surface (2) of the cutting edge (3).

7. A cutting tool in accordance with claim 5 or 6, wherein the layer system (4) includes at least two part layer systems (400) arranged one above the other on the surface (2) of the cutting edge (3),

8. A cutting tool in accordance with claim 7, wherein the layer systems (400) arranged one above the other comprises two identical part layer systems (400).

9. A cutting tool in accordance with any one of the claims 5 to 8, wherein the part layer system (400) includes a layer sequence of three part layers following each other, a Cr part layer (43), a CrXNC part layer (4200) and a [Cr₁-ₓOₓ]_{z}XₐC_{b}N_{c} part layer (41, 4100, 4101) in such a way that the Cr part layer (43) is respectively the nearest adjacent the surface (2) of the cutting edge (3) and the [Cr₁-ₓOₓ]_{z}XₐC_{b}N_{c} part layer (41, 4100, 4101) is respectively the nearest adjacent the outermost surface layer (41, 4100, 4101).

10. A cutting tool in accordance with any one of the claims 5 to 9, wherein a layer thickness (d) of the part layer (41, 42, 43, 421, 4100, 4200) lies between 0.05µm and 5µm.

11. A cutting tool in accordance with anyone of the previous claims, wherein a total thickness (D) of the layer system (4) lies between 0.01 µm and 50µm.

12. A cutting tool in accordance with any one of the claims 5 to 11, wherein a hardness of the part layer (41, 42, 43, 421, 4100, 4200) lies between 1000HV.01 and 3000HV.01.

13. A cutting tool in accordance with any one of the claims 5 to 12, wherein a residual stress of the part layer (41, 42, 421, 4100, 4200) lies between 0.1GPa and 5GPa.

14. A cutting tool in accordance with any one of the previous claims, wherein the cutting tool is a saw, a knife, a plane, a chisel, a dovetailer, a log saw, a floorboard saw, a shaped part cutter, a moulding cutter, or is a rotating cutting tool.

15. A method for the manufacture of a cutting tool (1) in accordance with any one of the previous claims, wherein the cutting tool (1) is coated using a PVD method including the following steps:
- making available a vacuum coating chamber with an arc vaporisation source;
- placing a cutting tool (1) on a rotatable substrate holder of the coating chamber;
- production of a high vacuum in the coating chamber;
- Formation of a surface coating comprising a layer system (4) on the cutting tool (1);
- the deposition of an outermost surface layer (41) of the layer system by means of arc vaporisation, wherein the outermost surface layer (41) is formed from a composition of the form [Cr₁₋ₓOₓ]_{z}XₐC_{b}N_{c} with 0.05 < x < 0.75 and 0 < z ≤ 1, 0 ≤ a<1, 0 ≤ b <1, 0 ≤ c < 1 and z+a+b+c = 1 and X being an element from the group of the chemical elements consisting of Si, B, Al, Mn, Fe, Co, Ni, Cu, Sc, Y, La, Th, the elements of the group of the lanthanides and the elements of the group 11a of the periodic system of the elements.

16. A method for the manufacture of a cutting tool (1) in accordance with claim 15, wherein the formation of a surface coating comprises the following steps:
- raising the temperature to 400° C for one hour by means of a radiative heater;
- the ion cleaning of a surface (2) of the cutting tool (1) for 30 minutes by means of Ar ions;
- the bombardment of the surface (2) for 2 minutes by means of Cr ions at a bias voltage of 800V;
- the deposition of a 100nm thick Cr part layer (43) as a bond layer on the surface (2) of the cutting tool (1) by means of arc vaporisation using a bias voltage of 100V;
- the introduction of a nitrogen gas and the adjustment of a bias voltage of 60V;
- the deposition of a CrN graded part layer (421) on the Cr bond layer (43) by means of arc vaporisation, wherein a nitrogen partial pressure is raised linearly from 0.1Pa to 2Pa during the deposition of the CrN gradient part layer, until a layer thickness (d) of the CrN gradient part layer (421) of 2µm is reached;
- the introduction of oxygen in a mixing ratio nitrogen to oxygen of 1 to 4.

## Revendications

1. Un outil de coupe pour le travail du bois ou d'un matériau à base de bois, en particulier le bois composite, ou d'une matière plastique, dans lequel un système de couches (4) est prévu sur une surface (2) d'un tranchant (3) de l'outil de coupe pour former un revêtement de surface, **caractérisé en ce qu'**une couche de surface la plus extérieure (41, 4100, 4101) du système de couches (4) est formée d'une composition de forme [Cr₁₋ₓOₓ]_{z}XₐC_{b}N_{c} avec 0.05 < x < 0.75 et0 < z ≤ 1, 0 ≤ a< 1, 0 ≤ b < 1, 0 ≤ c < 1, et z+a+b+c = 1, et X est un élément du groupe d'éléments chimiques constitué par Si, B, Al, Mn, Fe, Co, Ni, Cu, Sc, Y, La, Th, les éléments du groupe des lanthanides, et les éléments du groupe Ila du tableau périodique des éléments.

2. Un outil de coupe selon la revendication 1, dans lequel le groupe d'oxyde de chrome [Cr₁₋ₓOₓ]_{z} est CrO₂, CrO₃ ou Cr₂O₃.

3. Un outil de coupe selon la revendication 1, dans lequel le groupe d'oxyde de chrome [Cr₁₋ₓOₓ]_{z} est un oxyde de chrome sous-stœchiométrique ou un oxyde de chrome non-stoechiométrique à haute ou basse teneur en oxygène.

4. Un outil de coupe selon l'une des revendications précédentes, dans lequel a = 0 et / ou b = 0 et / ou c = 0.

5. Un outil de coupe selon l'une des revendications précédentes, dans lequel le système de couches (4) comprend en outre une couche partielle de CrN (42) et / ou une couche partielle à gradient de CrN (421) et / ou une couche partielle de Cr (43) et / ou une couche partielle de CrO et / ou une couche partielle de CrCO et / ou une couche partielle de [Cr₁₋ₓOₓ]_{z}XₐC_{b}N_{c}.

6. Un outil de coupe selon la revendication 5, dans lequel la couche partielle de Cr (43) est prévue comme couche adhésive directement sur la surface (2) du tranchant (3).

7. Un outil de coupe selon l'une des revendications 5 ou 6, dans lequel le système de couches (4) comprend au moins deux systèmes de couche partielle (400) superposés sur la surface (2) du tranchant (3).

8. Un outil de coupe selon la revendication 7, dans lequel les systèmes de couche partielle (400) superposés comprennent deux systèmes de couche partielle (400) identiques.

9. Un outil de coupe selon l'une des revendications 5 à 8, dans lequel le système de couche partielle (400) comprend une succession de couches de trois couches partielles successives, une couche partielle de Cr (43), une couche partielle de CrXNC (4200) et une couche partielle de [Cr₁-ₓOₓ]_{z}XₐC_{b}N_{c} (41, 4100, 4101) de telle sorte que la couche partielle de Cr (43) est respectivement la plus proche de la surface (2) du tranchant (3) et que la couche partielle de [Cr₁₋ₓOₓ]_{z}XₐC_{b}N_{c} (41, 4100, 4101) est respectivement la plus proche de la couche de surface la plus extérieure (41, 4100, 4101).

10. Un outil de coupe selon l'une des revendications 5 à 9, dans lequel une épaisseur de couche (d) de la couche partielle (41, 42, 43, 421, 4100, 4200) est comprise entre 0.05 mm et 5 mm.

11. Un outil de coupe selon l'une des revendications précédentes, dans lequel une épaisseur totale (D) du système de couches (4) est comprise entre 0.01 mm et 50 mm.

12. Un outil de coupe selon l'une des revendications 5 à11, dans lequel une dureté de la couche partielle (41, 42, 43, 421, 4100, 4200) est comprise entre 1000HV.01 et 3000HV.01.

13. Un outil de coupe selon l'une des revendications 5 à12, dans lequel une tension interne de la couche partielle (41, 42, 43, 421, 4100, 4200) est comprise entre 0.1GPa et 5GPa.

14. Un outil de coupe selon l'une des revendications précédentes, dans lequel l'outil de coupe est une scie, un couteau, un rabot, un ciseau à bois, un coupeur de dents, un coupeur de planches, un coupeur de planchers, un coupeur de pièces moulées, un coupeur de moulures ou un outil de coupe rotatif.

15. Un procédé pour la fabrication d'un outil de coupe (1) selon l'une des revendications précédentes, dans lequel l'outil de coupe (1) est revêtu en utilisant un procédé PVD, comprenant les étapes suivantes :
- Fournir une chambre de revêtement sous vide avec une source d'évaporation à l'arc électrique ;
- Placer un outil de coupe (1) sur un porte-substrat rotatif de la chambre de revêtement ;
- Création d'un vide poussé dans la chambre de revêtement ;
- Formation d'un revêtement de surface comprenant un système de couches (4) sur l'outil de coupe (1) ;
- Dépôt d'une couche de surface la plus extérieure (41) du système de couches (4) au moyen d'une évaporation à l'arc, dans lequel la couche de surface la plus extérieure est formée d'une composition de forme [Cr₁₋ₓOₓ]_{z}XₐC_{b}N_{c} avec 0.05 < x < 0.75 et 0 < z ≤ 1, 0 ≤ a < 1, 0 ≤ b < 1, 0 ≤ c < 1, et z+a+b+c = 1, et X est un élément du groupe d'éléments chimiques constitué par Si, B, Al, Mn, Fe, Co, Ni, Cu, Sc, Y, La, Th, les éléments du groupe des lanthanides, et les éléments du groupe Ila du tableau périodique des éléments.

16. Un procédé pour la fabrication d'un outil de coupe (1) selon la revendication 15, dans lequel la formation du revêtement de surface comprend les étapes suivantes :
- Augmentation de la température à 400°C pendant une heure à l'aide d'un radiateur à rayonnement ;
- Nettoyage ionique d'une surface (2) de l'outil de coupe (1) pendant 30 minutes au moyen d'ions Ar ;
- Bombardement de la surface (2) de l'outil de coupe (1) pendant 2 minutes au moyen d'ions Cr sous une tension de polarisation de 800V ;
- Dépôt d'une couche partielle de Cr (43) d'une épaisseur de 100nm en tant que couche adhésive sur la surface (2) de l'outil de coupe (1) par évaporation à l'arc électrique en utilisant une tension de polarisation du bias de 100 V ;
- Admission d'un gaz nitrogène et réglage d'une tension de bias de 60V ;
- Dépôt d'une couche partielle à gradient de CrN (421) sur la couche adhésive de Cr (43) au moyen d'une évaporation à l'arc électrique, dans lequel une pression partielle de nitrogène est augmentée linéairement de 0.1Pa à 2 Pa pendant le dépôt de la couche partielle à gradient de CrN (421), jusqu'à ce qu'une épaisseur de couche (d) de la couche partielle à gradient de CrN (421) est atteinte de 2mm ;
- Admission d'oxygène dans un rapport de mélange nitrogène/oxygène de 1 à 4.
